# EUROPEAN PATENT APPLICATION

(11) **EP 4 760 299 A1**
(43) Date of publication of application: **17.06.2026**
(21) Application number: 25749117.5
(22) Date of filing: 21.01.2025
(51) Int. Cl.: G01R 31/382, G01R 31/396, G01R 31/392, G01R 19/165, G01R 19/12, G01R 19/30, G01R 19/10, G01R 31/36

(54) **BATTERY DIAGNOSTIC DEVICE AND METHOD**

(30) Priority: 31.01.2024 KR 20240015291
(71) Applicant: LG Energy Solution, Ltd., Seoul 07335 (KR)
(72) Inventor: YOO, In-Sun, Daejeon 34122 (KR); RYU, Jong-Hun, Daejeon 34122 (KR); LEE, Jae-Woo, Daejeon 34122 (KR); BAE, Yoon-Jung, Daejeon 34122 (KR)
(74) Representative: Goddar, Heinz J.
(86) International application number: PCT/KR2025/001147
(87) International publication number: WO 2025/165030

(57) **Abstract**

A method for diagnosing a battery according to one aspect of the present disclosure includes a differential profile generating step of generating a differential profile representing a relationship between a differential capacity, which is obtained by differentiating a capacity of a battery with respect to a voltage of the battery, and the voltage, for each predetermined diagnosis cycle; a target peak detecting step of detecting a target peak in which a differential capacity value decreases and then increases or a voltage value increases and then decreases as a usage time of the battery increases, among peaks of the differential profile; a peak information obtaining step of obtaining target peak information including the differential capacity value and the voltage value of the target peak from each of the plurality of differential profiles generated while the diagnosis cycle is repeated multiple times; and a diagnosing step of diagnosing a state of the battery based on the target peak information obtained from the plurality of differential profiles.

## Description

### TECHNICAL FIELD

This application is based on and claims priority from Korean Patent Application No. 10-2024-0015291, filed on January 31, 2024, with the Korean Intellectual Property Office, the disclosure of which is incorporated herein in its entirety by reference.

The present disclosure relates to an apparatus and method for diagnosing a battery, and more particularly, to an apparatus and method for non-destructively diagnosing a battery capable of charging and discharging.

### BACKGROUND ART

Recently, the demand for portable electronic products such as notebook computers, digital cameras and portable telephones has increased sharply, and electric vehicles, energy storage systems, robots, satellites and the like have been developed in earnest. Accordingly, high-performance batteries allowing charging and discharging and having high energy density are being actively studied.

Types of rechargeable batteries include lithium batteries that use lithium ions, such as lithium-ion batteries or lithium-ion polymer batteries, and nickel cadmium batteries, nickel hydrogen batteries, and nickel zinc batteries. Among these, lithium batteries have the advantages of having a relatively long lifespan, a very low self-discharge rate, and high energy density because they have almost no memory effect compared to batteries that use nickel, and thus their application range is gradually expanding.

The positive electrode and negative electrode of these batteries gradually deteriorate as the charge and discharge cycles are repeated, and they no longer maintain the electrical capacity they had at the time of manufacture but are deteriorated. Therefore, in order to accurately predict the usable time, remaining life, and replacement time of the battery, an accurate diagnosis of the battery state is required.

However, since the existing technology simply diagnoses the battery through the SOH (State of Health) of the entire battery, there is a problem in that the accuracy and reliability of the diagnosis result are low, and as a result, efficient management corresponding to the current state of the battery is difficult.

### DISCLOSURE

### Technical Problem

The technical challenge that the present disclosure seeks to solve is to provide an apparatus and method for diagnosing a battery that enables real-time diagnosis of the battery state while improving the accuracy and reliability of the diagnosis result.

Another technical challenge that the present disclosure seeks to solve is to provide an apparatus and method for diagnosing a battery that enables efficient battery management.

### Technical Solution

A method for diagnosing a battery according to one aspect of the present disclosure comprises a differential profile generating step of generating a differential profile representing a relationship between a differential capacity, which is obtained by differentiating a capacity of a battery with respect to a voltage of the battery, and the voltage, for each predetermined diagnosis cycle; a target peak detecting step of detecting a target peak in which a differential capacity value decreases and then increases or a voltage value increases and then decreases as a usage time of the battery increases, among peaks of the differential profile; a peak information obtaining step of obtaining target peak information including the differential capacity value and the voltage value of the target peak from each of the plurality of differential profiles generated while the diagnosis cycle is repeated multiple times; and a diagnosing step of detecting a trend switching point at which a change trend of at least one of the differential capacity value and the voltage value of the target peak switches from an increasing trend to a decreasing trend or from a decreasing trend to an increasing trend over time based on the target peak information obtained from the plurality of differential profiles, and diagnosing a state of the battery by referring to the trend switching point.

In an embodiment, the target peak detecting step may include a step of dividing an entire voltage section of the differential profile into a plurality of sub-sections different from each other and determining a target sub-section among the plurality of sub-sections; and a step of detecting a peak located in the target sub-section among the peaks of the differential profile as the target peak.

In an embodiment, the target sub-section may be a section from 4.0 [V] to 4.2 [V].

In an embodiment, the diagnosing step may include a step of detecting a first trend switching point at which the change trend of the differential capacity value switches from a decreasing trend to an increasing trend over time; and a step of determining the state of the battery before the first trend switching point as a first deterioration state, and determining the state of the battery after the first trend switching point as a second deterioration state.

In an embodiment, the diagnosing step may further include a step of determining that the battery needs to be replaced when the differential capacity value of the target peak exceeds a predetermined first threshold value after the first trend switching point.

In an embodiment, the diagnosing step may include a step of detecting a second trend switching point at which the change trend of the voltage value switches from an increasing trend to a decreasing trend over time; and a step of determining the state of the battery before the second trend switching point as a third deterioration state, and determining the state of the battery after the second trend switching point as a fourth deterioration state.

In an embodiment, the diagnosing step may further include a step of determining that the battery needs to be replaced when the voltage value of the target peak decreases below a predetermined second threshold value after the second trend switching point.

In an embodiment, the method for diagnosing a battery may further comprise a battery managing step of lowering a voltage upper limit of the battery when the trend switching point is detected in the diagnosing step.

In an embodiment, the battery managing step may include a step of calculating a difference value between a first voltage value of the target peak obtained from a latest differential profile generated most recently among the plurality of differential profiles and a second voltage value of the target peak obtained from a differential profile generated immediately before the latest differential profile; and a step of lowering the voltage upper limit of the battery in response to the difference value.

An apparatus for diagnosing a battery according to another aspect of the present disclosure comprises a differential profile generating unit configured to generate a differential profile representing a relationship between a differential capacity, which is obtained by differentiating a capacity of a battery with respect to a voltage of the battery, and the voltage, for each predetermined diagnosis cycle; a peak information obtaining unit configured to detect a target peak in which a differential capacity value decreases and then increases or a voltage value increases and then decreases as a usage time of the battery increases, among peaks of the differential profile, and obtain target peak information including the differential capacity value and the voltage value of the target peak from each of the plurality of differential profiles generated while the diagnosis cycle is repeated multiple times; and a diagnosing unit configured to detect a trend switching point at which a change trend of at least one of the differential capacity value and the voltage value of the target peak switches from an increasing trend to a decreasing trend or from a decreasing trend to an increasing trend over time based on the target peak information obtained from the plurality of differential profiles, and diagnose a state of the battery by referring to the trend switching point.

In an embodiment, the diagnosing step unit may be configured to detect a first trend switching point at which the change trend of the differential capacity value switches from a decreasing trend to an increasing trend over time, determine the state of the battery before the first trend switching point as a first deterioration state, and determine the state of the battery after the first trend switching point as a second deterioration state.

In an embodiment, the diagnosing unit may be configured to detect a second trend switching point at which the change trend of the voltage value switches from an increasing trend to a decreasing trend over time, determine the state of the battery before the second trend switching point as a third deterioration state, and determine the state of the battery after the second trend switching point as a fourth deterioration state.

In an embodiment, the apparatus for diagnosing a battery may further comprise a battery management unit configured to lower a voltage upper limit of the battery when the trend switching point is detected.

A battery pack according to still another aspect of the present disclosure comprises the apparatus for diagnosing a battery as described above.

A vehicle according to still another aspect of the present disclosure comprises the apparatus for diagnosing a battery as described above.

### Advantageous Effects

According to an embodiment of the present disclosure, since a battery is diagnosed by generating a differential profile representing the relationship between the voltage and the differential capacity, which is obtained by differentiating the capacity of the battery with respect to the voltage of the battery, at each predetermined diagnosis cycle, the state of the battery may be diagnosed in real time.

In addition, according to an embodiment of the present disclosure, by detecting a target peak that shows a specific behavior over time among the peaks appearing in the differential profile and diagnosing the battery based on a change trend of at least one of the differential capacity value and the voltage value of the target peak, the change in the state of the battery may be precisely confirmed, and the accuracy and reliability of the diagnosis result may be improved.

In addition, according to an embodiment of the present disclosure, by reducing the voltage upper limit of the battery in response to the difference value between the first voltage value of the target peak obtained from the latest differential profile generated most recently among a plurality of differential profiles generated for each main cycle and the second voltage value of the target peak obtained from the differential profile generated immediately before the latest differential profile, efficient management corresponding to the current state of the battery is possible, and the life of the battery may be extended and safety may be improved.

Furthermore, a person having ordinary skill in the art to which the present disclosure belongs will be able to clearly understand from the following description that various embodiments according to the present disclosure can solve various technical problems not mentioned above.

### DESCRIPTION OF DRAWINGS

FIG. 1 is a block diagram showing an apparatus for diagnosing a battery according to an embodiment of the present disclosure.
FIG. 2 is a drawing showing an example of a capacity-voltage profile.
FIG. 3 is a drawing showing an example of a differential profile.
FIG. 4 is a graph showing a general trend of a differential capacity value of a peak of the differential profile changing over time.
FIG. 5 is a graph showing a general trend of a voltage value of the peak of the differential profile changing over time.
FIG. 6 is an enlarged view showing the A1 area of the differential profile shown in FIG. 3.
FIG. 7 is a drawing showing a location of a target peak at the beginning of the battery life.
FIG. 8 is a drawing showing a location of the target peak at the end of the battery life.
FIG. 9 is a graph showing the trend of the differential capacity value of the target peak changing over time.
FIG. 10 is a graph showing the trend of the voltage value of the target peak changing over time.
FIG. 11 is a flow chart showing a method for diagnosing a battery according to an embodiment of the present disclosure.
FIG. 12 is a flow chart showing a battery management process of the method for diagnosing a battery according to an embodiment of the present disclosure.
FIG. 13 is a drawing showing a battery pack according to an embodiment of the present disclosure.
FIG. 14 is a drawing showing a vehicle according to an embodiment of the present disclosure.

### BEST MODE

Hereinafter, in order to clarify the solution corresponding to the technical challenge of the present disclosure, embodiments according to the present disclosure will be described in detail with reference to the attached drawings. However, when explaining the present disclosure, if a description of a related publicly known technology obscures the gist of the present disclosure, the description thereof may be omitted. In addition, the terms used in this specification are terms defined in consideration of the functions in the present disclosure, and these may vary depending on the intention or custom of the designer, manufacturer, etc. Therefore, the definitions of the terms described below should be made based on the contents throughout this specification.

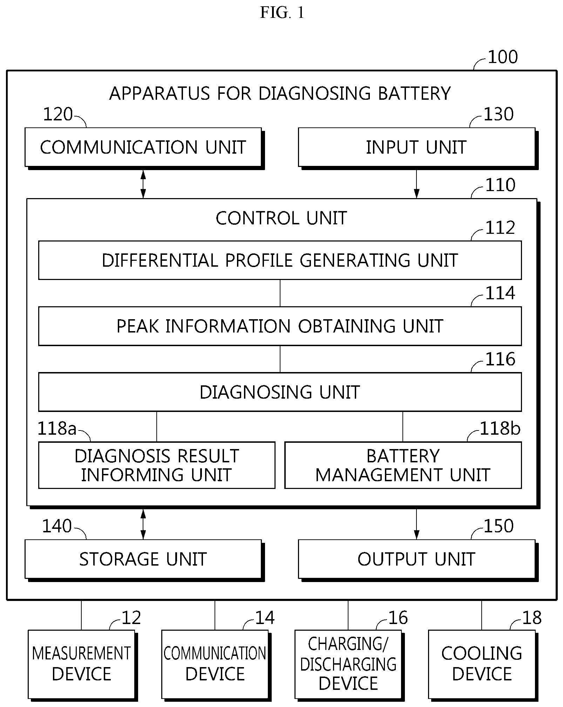

FIG. 1 is a block diagram showing an apparatus 100 for diagnosing a battery according to an embodiment of the present disclosure.

As illustrated in FIG. 1, an apparatus 100 for diagnosing a battery according to an embodiment of the present disclosure includes a control unit 110. The control unit 110 controls the overall operation of the apparatus 100 for diagnosing a battery and is configured to non-destructively diagnose a battery capable of charging and discharging.

The control unit 110 may include one or more general-purpose processors or one or more ASICs (application-specific integrated circuits) for executing the battery diagnosis logic, and may optionally further include hardware such as registers and memories according to an embodiment. The control unit 110 may be configured with a combination of hardware such as a processor and software such as a computer program. That is, the battery diagnosis logic of the control unit 110 may be configured as a computer program and stored in the memory of the control unit 110 or a storage unit 140 described below, and the stored computer program may be configured to be executed through the hardware of the control unit 110.

Meanwhile, the control unit 110 includes, as detailed components, a differential profile generating unit 112, a peak information obtaining unit 114, and a diagnosing unit 116.

The differential profile generating unit 112 is configured to generate a differential profile representing the relationship between the differential capacity, which is obtained by differentiating the capacity of a diagnosis target battery with respect to the voltage of the battery, and the voltage, for each predetermined diagnosis cycle.

For example, when the diagnosis cycle arrives, the differential profile generating unit 112 may measure electrical values of the battery while the battery is being charged or discharged, and generate a profile representing the relationship between the capacity and voltage of the battery.

Next, the differential profile generating unit 112 may generate the differential profile by differentiating the profile with respect to the voltage of the battery.

The peak information obtaining unit 114 is configured to detect a target peak in which the differential capacity value decreases and then increases or the voltage value increases and then decreases as the usage time of the battery increases, among the peaks appearing in the differential profile, and obtain target peak information from each of the plurality of differential profiles generated while the diagnosis cycle is repeated multiple times.

The target peak information includes the differential capacity value and voltage value of the target peak appearing in each differential profile.

In an embodiment, the peak information obtaining unit 114 may divide the entire voltage section of each differential profile into a plurality of sub-sections different from each other, determine a target sub-section among the plurality of sub-sections, and detect a peak located in the target sub-section among the peaks appearing in each differential profile as the target peak.

In this case, the target sub-section may be determined as a section from 4.0 [V] to 4.2 [V].

In this way, the peak information obtaining unit 114 may reduce the amount of computation required for target peak detection and shorten the target peak detection time by determining the target sub-section in advance where the target peak is detected.

The diagnosing unit 116 confirms a change trend of the differential capacity value and voltage value of the target peak over time based on the target peak information obtained from the plurality of differential profiles, and diagnoses the battery based on the confirmed change trend.

In particular, the diagnosing unit 116 detects a trend switching point at which a change trend of at least one of the differential capacity value and the voltage value of the target peak switches from an increasing trend to a decreasing trend or from a decreasing trend to an increasing trend over time based on the target peak information, and diagnoses the state of the battery with reference to the trend switching point.

For example, the diagnosing unit 116 may determine that a change in the state of the battery has occurred if the change trend of the differential capacity value changes from a first trend in which the differential capacity value gradually decreases over time to a second trend in which the differential capacity value gradually increases over time.

That is, the diagnosing unit 116 may detect the first trend switching point where the change trend of the differential capacity value switches from a decreasing trend to an increasing trend over time, determine the state of the battery before the first trend switching point as a first deterioration state, and determine the state of the battery after the first trend switching point as a second deterioration state that is different from the first deterioration state.

For example, the first deterioration state may be a state in which control of the charge/discharge conditions of the battery is required. Additionally, the second deterioration state may be a state in which the voltage upper limit of the battery must be reduced.

In an embodiment, the diagnosing unit 116 may determine that the battery needs to be replaced, if the differential capacity value of the target peak exceeds a predetermined first threshold value over time after the first trend switching point.

In addition, the diagnosing unit 116 may determine that a change in the state of the battery has occurred if the change trend of the voltage value changes from a third trend in which the voltage value gradually increases over time to a fourth trend in which the voltage value gradually decreases over time.

For example, the diagnosing unit 116 may detect a second trend switching point at which the change trend of the voltage value switches from an increasing trend to a decreasing trend over time, determine the state of the battery before the second trend switching point as a third deterioration state, and determine the state of the battery after the second trend switching point as a fourth deterioration state that is different from the third deterioration state.

For example, the third deterioration state may be a state in which control of the charge/discharge conditions of the battery is required. Additionally, the fourth deterioration state may be a state in which the voltage upper limit of the battery must be reduced.

In an embodiment, the diagnosing unit 116 may determine that the battery needs to be replaced if the voltage value of the target peak decreases below a predetermined second threshold value over time after the second trend switching point.

In an embodiment, the diagnosing unit 116 may determine that a state change of the battery has occurred when the change trend of the differential capacity value changes from a decreasing trend to an increasing trend and when the change trend of the voltage value changes from an increasing trend to a decreasing trend.

In addition, the diagnosing unit 116 may determine that the battery needs to be replaced if the differential capacity value of the target peak exceeds the first threshold value or the voltage value of the target peak decreases below a predetermined second threshold value after the change trend of the differential capacity value changes from a decreasing trend to an increasing trend and the change trend of the voltage value changes from an increasing trend to a decreasing trend.

In an embodiment, the control unit 110 may further include a diagnosis result informing unit 118a. The diagnosis result informing unit 118a may be configured to output a visual, auditory or audio-visual notification signal corresponding to the diagnosis result of the battery using a predetermined output device.

In an embodiment, the control unit 110 may further include a battery management unit 118b. The battery management unit 118b may be configured to control a charging condition and/or a discharging condition of the battery according to the diagnosis result of the diagnosing unit 116.

For example, the battery management unit 118b may control the charging/discharging device 16 described later to appropriately adjust the voltage range of the battery, the current rate of the charging current and/or the discharging current of the battery, etc. In addition, the battery management unit 118b may control the cooling device 18 described later to lower the temperature of the battery.

In an embodiment, when degradation of the battery is diagnosed, the battery management unit 118b may be configured to lower the voltage of the battery upon completion of charge in response to a difference between the current voltage value of the target peak and a predetermined reference voltage value. The reference voltage value may be a voltage value of the target peak measured at the Beginning of Life (BOL) point of the battery, or a voltage value determined during the design of the battery.

In an embodiment, the battery management unit 118b may be configured to lower the voltage upper limit value of the battery when the first or second trend switching point described above is detected.

For example, the battery management unit 118b may calculate a difference value between the current voltage value of the target peak obtained from the latest differential profile generated most recently among the plurality of differential profiles generated for each diagnosis cycle and the previous voltage value of the target peak obtained from the differential profile generated immediately before the latest differential profile.

Also, the battery management unit 118b may lower the voltage upper limit of the battery in response to the calculated difference value.

The differential profile generating unit 112, the peak information obtaining unit 114, the diagnosing unit 116, the diagnosis result informing unit 118a and the battery management unit 118b of the above-described control unit 110 may be implemented as a combination of a processor and a program executed by the processor. In this case, the control unit 110 may be implemented as a single processor, or may be implemented as two or more processors that are interconnected.

In an embodiment, the apparatus 100 for diagnosing a battery may further include a communication unit 120. The communication unit 120 may be configured to receive data transmitted from other servers or communication terminals via a wired and/or wireless communication network and transmit the data to the control unit 110, or transmit control signals, diagnostic data, etc. processed by the control unit 110 to the other servers or communication terminals. To this end, the communication unit 120 may include a communication modem that performs wired and/or wireless communication.

In an embodiment, the apparatus 100 for diagnosing a battery may further include an input unit 130. The input unit 130 may be configured to receive commands or data from a system operator or an administrator. For this purpose, the input unit 130 may include an input device such as a keyboard, operating buttons, or a touch panel.

In an embodiment, the apparatus 100 for diagnosing a battery may further include a storage unit 140. The storage unit 140 may be configured to store and manage data required for the operation of the apparatus 100 for diagnosing a battery. To this end, the storage unit 140 may include one or two or more of a ROM, a RAM, an EEPROM, a register, a flash memory, a CD-ROM, a magnetic tape, a hard disk, a floppy disk, and an optical data recording device.

In an embodiment, the apparatus 100 for diagnosing a battery may further include an output unit 150. The output unit 150 may be configured to visually, audibly or audiovisually output a notification signal of the diagnosis result informing unit 118a. For this purpose, the output unit 150 may include a visual output device such as a light-emitting diode, a monitor, a display panel or a touch screen. In addition, the output unit 150 may further include a sound generating device such as a speaker.

In an embodiment, the apparatus 100 for diagnosing a battery may be configured to be interlocked with a measurement device 12 for measuring voltage, charging current and/or discharging current of the battery, a communication device 14 for communicating with another device, a charging/discharging device 16 for charging and discharging the battery, a cooling device 18 for cooling the battery, etc.

In another embodiment, the apparatus 100 for diagnosing a battery according to the present disclosure may include one or more of the measurement device 12, the communication device 14, the charging/discharging device 16, and the cooling device 18 described above.

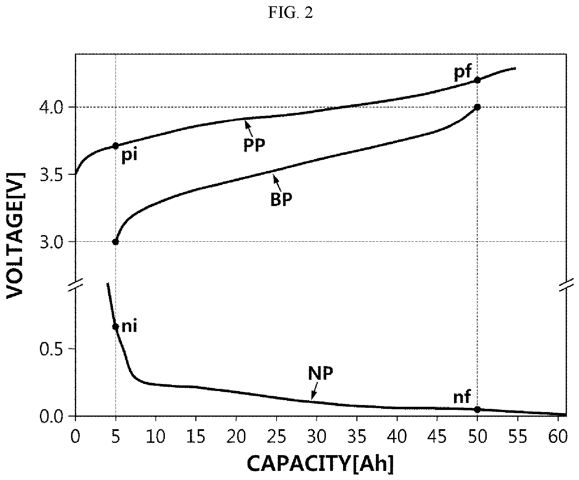

FIG. 2 is a drawing showing an example of a capacity-voltage profile BP.

As illustrated in FIG. 2, the differential profile generating unit 112 may generate a profile BP representing the relationship between the capacity and voltage of the battery by measuring the electrical values of the battery while the battery is being charged or discharged when a diagnosis cycle arrives.

In this case, the differential profile generating unit 112 may find the positive electrode profile PP and the negative electrode profile NP which generate a curve similar to the profile BP of the battery by mutual combination, and provide the start point pi and the end point pf of the positive electrode profile PP and the start point ni and the end point nf of the negative electrode profile NP to the diagnosing unit 116. The diagnosing unit 116 may use the start point pi and the end point pf of the positive electrode profile PP and the start point ni and the end point nf of the negative electrode profile NP as diagnostic factors representing the state of the battery.

Additionally, the differential profile generating unit 112 may generate a differential profile by differentiating the profile BP with respect to the voltage of the battery.

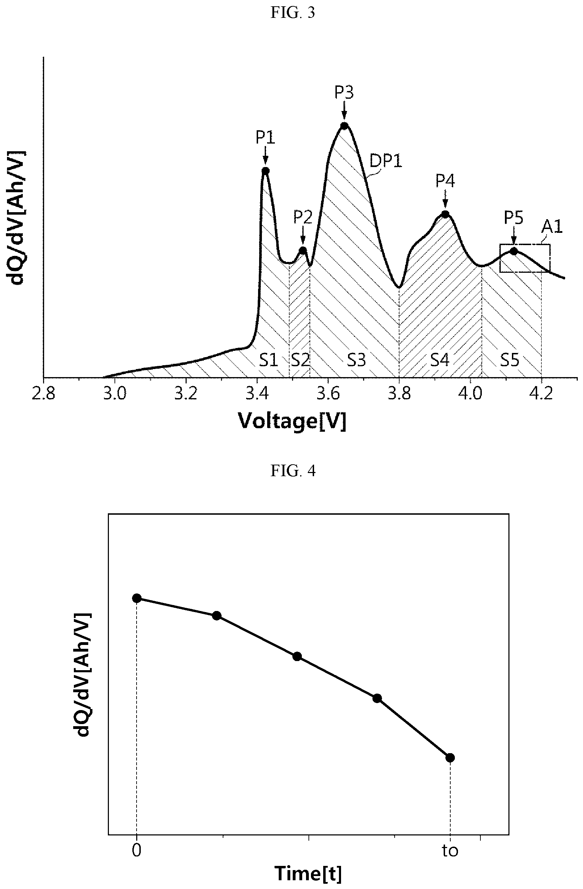

FIG. 3 is a drawing showing an example of a differential profile DP.

As illustrated in FIG. 3, the differential profile generating unit 112 is configured to generate a differential profile DP1 representing the relationship between the differential capacity (dQ/dV), which is obtained by differentiating the capacity of the battery with respect to the voltage of the battery, and the voltage, for each predetermined diagnosis cycle.

Then, the peak information obtaining unit 114 is configured to obtain target peak information from each differential profile generated for each diagnosis cycle. Here, the target peak information may include a differential capacity value and a voltage value of the target peak P5 detected among a plurality of peaks P1 to P5 of the corresponding differential profile DP1.

The target peak P5 is a peak that exhibits a unique behavior as the usage time of the battery increases. That is, the target peak P5 may be a peak in which the differential capacity value decreases and then increases, or the voltage value increases and then decreases, as the usage time of the battery increases.

That is, the entire voltage section of the differential profile DP1 may be divided into a plurality of sub-sections S1 to S5 based on peaks P1 to P5 of the differential profile DP1.

Among these plurality of sub-sections S1 to S5, a target sub-section S5 that exhibits a peak that exhibits different behavior from other peaks over time may be determined in advance. The target sub-section S5 may be determined as a section from 4.0 [V] to 4.2 [V].

For example, the peak information obtaining unit 114 may detect the peak P5, located in the target sub-section S5, among the plurality of peaks P1 to P5 of each differential profile, as the target peak.

FIG. 4 is a graph showing a general trend of a differential capacity value of a peak of the differential profile changing over time.

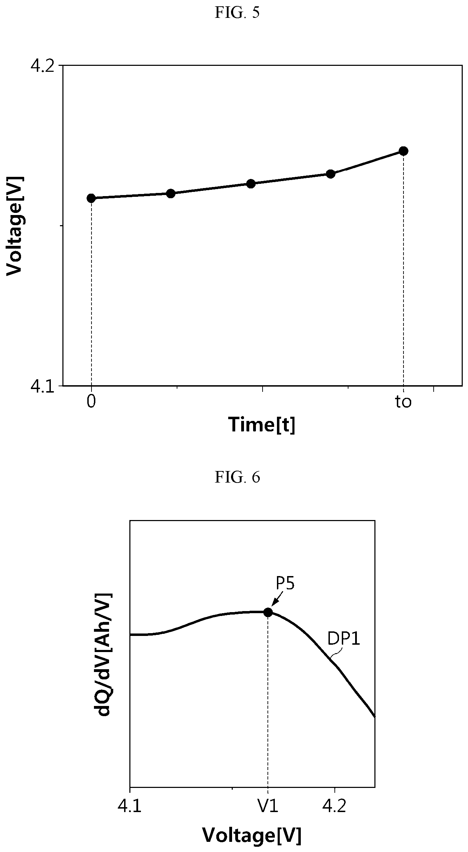

FIG. 5 is a graph showing a general trend of a voltage value of the peak of the differential profile changing over time.

As shown in FIGS. 4 and 5, among the plurality of peaks P1 to P5 of the differential profile DP1, except for the target peak P5, the other peaks show a trend in which the differential capacity value, i.e., intensity, decreases and the voltage value increases as time elapses or the number of charge/discharge cycles increases. This trend is analyzed to be due to the loss of the positive electrode capacity of the battery and the increase in resistance.

On the other hand, the target peak P5 shows a different trend from the trends shown in FIGS. 4 and 5.

FIG. 6 is an enlarged view showing the A1 area of the differential profile shown in FIG. 3.

As shown in FIG. 6, the target peak P5 of the differential profile DP1 generated at the BOL point of the battery may have a voltage value V1.

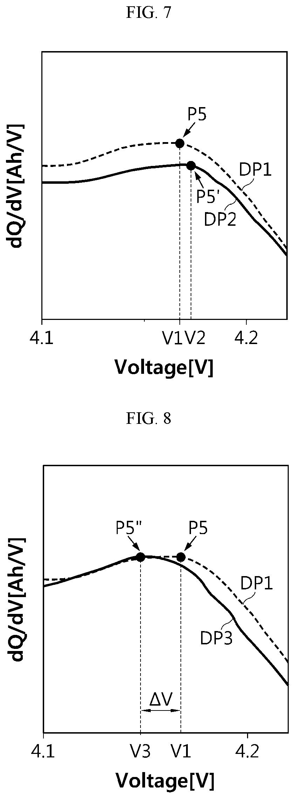

FIG. 7 is a drawing showing a location of a target peak P5' at the beginning of the battery life.

As shown in FIG. 7, at the target peak P5' of the differential profile DP2 generated at the beginning of the battery's life, the differential capacity value may decrease, as in the general trend mentioned above, and its voltage value may have a voltage value V2 that is greater than the previous voltage value V1.

FIG. 8 is a drawing showing a location of the target peak P5" at the end of the battery life.

As shown in FIG. 8, at the target peak P5" of the differential profile DP3 generated at the end of the battery's life, unlike the general trend mentioned above, the differential capacity value increases, and its voltage value V3 is smaller than the voltage value V1.

The peculiar behavior of these target peaks P5, P5', P5" is related to the loss of positive electrode capacity and increase in internal resistance of the battery.

Therefore, the diagnosing unit 116 may confirm the change trend of the differential capacity value and voltage value of the target peak over time based on the peak information obtained while the diagnosis cycle is repeated multiple times, and diagnose the battery based on the confirmed change trend.

In addition, if it is diagnosed that the battery is deteriorated, the battery management unit 118b may lower the voltage upper limit of the battery, that is, the voltage value of the battery at which charging of the battery is terminated, in response to the difference (ΔV) between the current voltage value V3 of the target peak P5" and the voltage value V1, thereby extending the life of the battery and ensuring the safety of the battery.

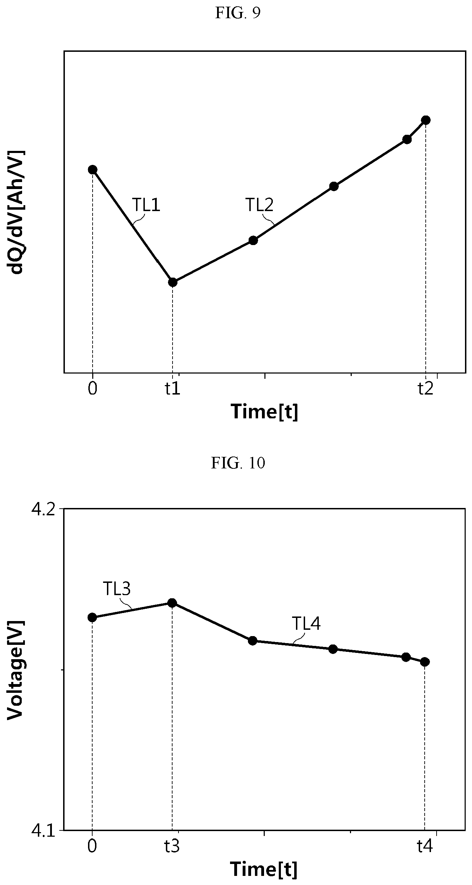

FIG. 9 is a graph showing the trend of the differential capacity value of the target peak changing over time.

As illustrated in FIG. 9, the change trend of the differential capacity value of the target peak P5 described above may exhibit a first trend TL1 that gradually decreases over time, and then change to a second trend TL2 that gradually increases over time after the first trend switching point t1.

In this case, the diagnosing unit 116 may detect the first trend switching point t1 at which the change trend of the differential capacity value switches from a decreasing trend to an increasing trend over time, determine the state of the battery before the first trend switching point t1 as a first deterioration state, and determine the state of the battery after the first trend switching point t1 as a second deterioration state that is different from the first deterioration state.

FIG. 10 is a graph showing the trend of the voltage value of the target peak changing over time.

As illustrated in FIG. 10, the change trend of the voltage value of the target peak P5 described above may show a third trend TL3 that gradually increases over time, and then change to a fourth trend TL4 that gradually decreases over time from the second trend switching point t3.

In this case, the diagnosing unit 116 may detect the second trend switching point t3 at which the change trend of the voltage value switches from an increasing trend to a decreasing trend over time, determine the state of the battery before the second trend switching point t3 as a third deterioration state, and determine the state of the battery after the second trend switching point t3 as a fourth deterioration state that is different from the third deterioration state.

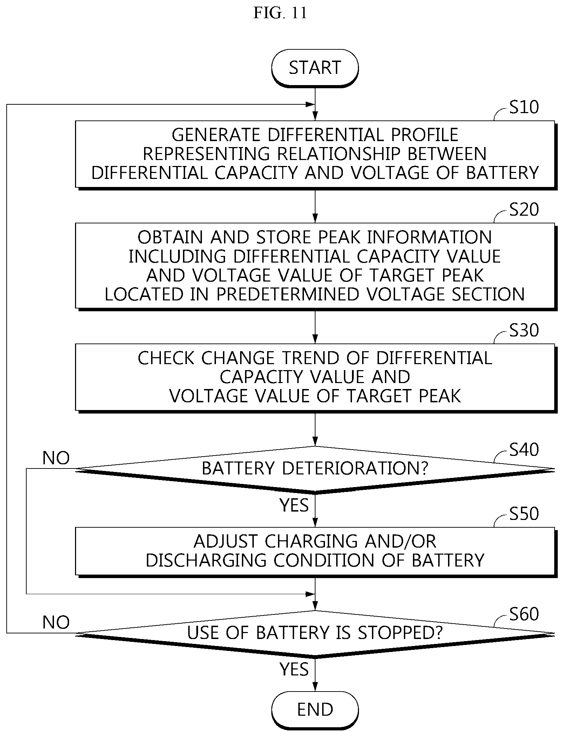

FIG. 11 is a flow chart showing a method for diagnosing a battery according to an embodiment of the present disclosure.

As illustrated in FIG. 11, a method for diagnosing a battery according to the present disclosure is a method for non-destructively diagnosing a battery capable of charging and discharging, and may be performed by a processor.

First, the processor generates a differential profile representing the relationship between a differential capacity, which is obtained by differentiating the capacity of the diagnosis target battery with respect to the voltage of the battery, and the voltage at each predetermined diagnosis cycle (S10).

For example, when the diagnosis cycle arrives, the processor may measure the electrical values of the battery while the battery is being charged or discharged, and generate a profile that represents the relationship between the capacity and voltage of the battery.

Then, the processor may generate the differential profile by differentiating the profile with respect to the voltage of the battery.

Next, the processor detects a target peak, among the peaks appearing in the differential profile, in which the differential capacity value decreases and then increases or the voltage value increases and then decreases as the usage time of the battery increases, and obtains and stores target peak information from each of the plurality of differential profiles generated while the diagnosis cycle is repeated multiple times (S20).

In this case, the target peak information includes the differential capacity value and voltage value of the target peak that appear in each differential profile.

In an embodiment, the processor may divide the entire voltage section of each differential profile into a plurality of sub-sections different from each other, determine a target sub-section among the plurality of sub-sections, and detect a peak located in the target sub-section among the peaks appearing in each differential profile as the target peak.

In this case, the target sub-section may be determined as a section from 4.0 [V] to 4.2 [V].

In this way, the processor may reduce the amount of computation required for target peak detection and shorten the target peak detection time by determining the target sub-section in advance where the target peak is detected.

Then, based on the target peak information obtained from the plurality of differential profiles, the processor checks the change trend of the differential capacity value and voltage value of the target peak over time, and diagnoses the battery based on the checked change trend (S30).

In particular, the processor detects a trend switching point at which a change trend of at least one of the differential capacity value and the voltage value of the target peak switches from an increasing trend to a decreasing trend or from a decreasing trend to an increasing trend over time based on the target peak information, and diagnoses the state of the battery by referring to the trend switching point.

For example, the processor may determine that a change in the deterioration or deterioration state of the battery has occurred if the change trend of the differential capacity value changes from a first trend in which the differential capacity value gradually decreases over time to a second trend in which the differential capacity value gradually increases over time (S40).

That is, the processor may detect the first trend switching point where the change trend of the differential capacity value switches from a decreasing trend to an increasing trend over time, determine the state of the battery before the first trend switching point as a first deterioration state, and determine the state of the battery after the first trend switching point as a second deterioration state that is different from the first deterioration state.

For example, the first deterioration state may be a state in which control of the charge/discharge conditions of the battery is required. Additionally, the second deterioration state may be a state in which the voltage upper limit of the battery must be reduced.

In an embodiment, the processor may determine that the battery needs to be replaced if the differential capacity value of the target peak exceeds a predetermined first threshold value over time, after the first trend switching point.

In addition, the processor may determine that a change in the deterioration or deterioration state of the battery has occurred if the change trend of the voltage value has changed from a third trend in which the voltage value gradually increases over time to a fourth trend in which the voltage value gradually decreases over time.

For example, the processor may detect a second trend switching point where the change trend of the voltage value switches from an increasing trend to a decreasing trend over time, determine the state of the battery before the second trend switching point as a third deterioration state, and determine the state of the battery after the second trend switching point as a fourth deterioration state that is different from the third deterioration state.

For example, the third deterioration state may be a state in which control of the charge/discharge conditions of the battery is required. Additionally, the fourth deterioration state may be a state in which the voltage upper limit of the battery must be reduced.

In an embodiment, the processor may determine that the battery needs to be replaced if the voltage value of the target peak decreases below a predetermined second threshold value over time, after the second trend switching point.

In an embodiment, the processor may determine that a state change of the battery has occurred when a change trend of the differential capacity value changes from a decreasing trend to an increasing trend and a change trend of the voltage value changes from an increasing trend to a decreasing trend.

In addition, the processor may determine that the battery needs to be replaced if the differential capacity value of the target peak exceeds the first threshold value or the voltage value of the target peak decreases below a predetermined second threshold value, after the change trend of the differential capacity value changes from a decreasing trend to an increasing trend and the change trend of the voltage value changes from an increasing trend to a decreasing trend.

Then, the processor adjusts the charging condition and/or the discharging condition of the battery according to the diagnosis result of the battery (S50).

For example, the processor may control the charging/discharging device 16 described with reference to FIG. 1 to appropriately adjust the voltage range of the battery, the current rate of the charging current and/or the discharging current of the battery, etc. In addition, the battery management unit 118b may control the cooling device 18 with reference to FIG. 1 to lower the temperature of the battery.

In an embodiment, if degradation of the battery is diagnosed, the processor may be configured to reduce the voltage of the battery upon completion of charge in response to a difference between the current voltage value of the target peak and a predetermined reference voltage value. The reference voltage value may be a voltage value of the target peak measured at the Beginning of Life (BOL) point of the battery, or a voltage value determined during the design of the battery.

Meanwhile, the processor may output a visual, auditory or audio-visual notification signal corresponding to the diagnosis result of the battery using a predetermined output device.

Next, the processor may repeat the above-described steps (S10 to S50) for each diagnosis cycle until the battery is no longer in use (S60).

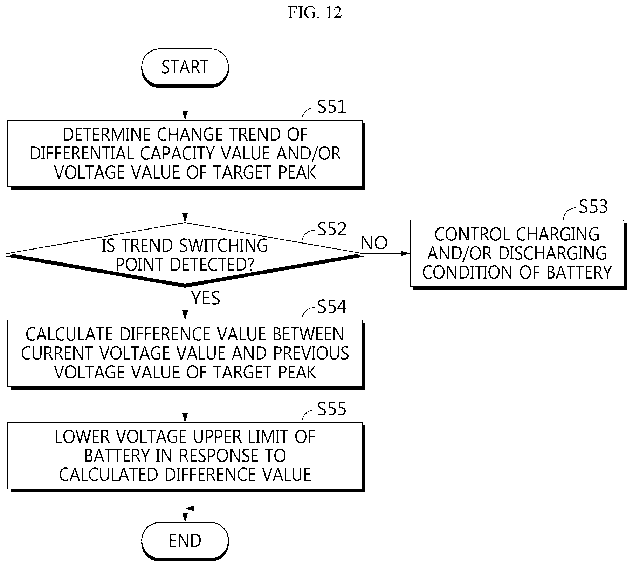

FIG. 12 is a flow chart showing a battery management process of the method for diagnosing a battery according to an embodiment of the present disclosure.

As illustrated in FIG. 12, the processor may determine a change trend of the differential capacity value and/or voltage value of the target peak over time based on a plurality of sequentially generated differential profiles (S51).

And, the processor may manage the battery in a different way depending on whether the first trend switching point, where the change trend of the differential capacity value of the target peak switches from a decreasing trend to an increasing trend over time, or the second trend switching point, where the change trend of the voltage value of the target peak switches from an increasing trend to a decreasing trend over time, is detected.

If both the first trend switching point and the second trend switching point are not detected, the processor may typically control the charge and discharge conditions of the battery. For example, the processor may lower the current rate of the charge current and/or the discharge current of the battery, or lower the temperature of the battery (S52, S53).

On the other hand, if at least one of the first trend switching point and the second trend switching point is detected, the processor may calculate a difference value between the current voltage value of the target peak obtained from the latest differential profile generated most recently among the plurality of differential profiles and the previous voltage value of the target peak obtained from the differential profile generated immediately before the latest differential profile (S54).

And the processor may lower the voltage upper limit of the battery in response to the calculated difference value (S55).

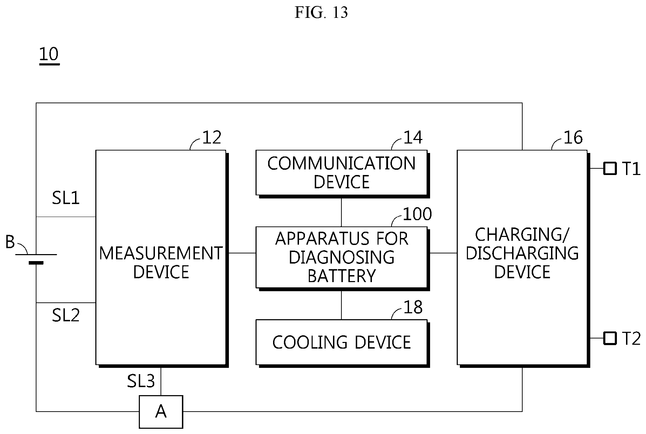

FIG. 13 is a drawing showing a battery pack 10 according to an embodiment of the present disclosure.

As illustrated in FIG. 13, the battery pack 10 includes a battery B allowing charging and discharging and the apparatus 100 for diagnosing a battery according to the present disclosure. In an embodiment, the battery pack 10 may optionally further include a measurement device 12, a communication device 14, a charging/discharging device 16, and a cooling device 18.

The measurement device 12 may be configured to measure the voltage and/or current of the battery B. To this end, the measurement device 12 may include a voltage sensor for sensing the voltage of the battery B and/or a current sensor 12b for sensing the current of the battery B.

The measurement device 12 may measure the voltage of the battery B through the first sensing line SL1 and the second sensing line SL2. In addition, the measurement device 12 may measure the current of the battery B through the third sensing line SL3 connected to the current measurement circuit A. The current measurement circuit A may include a shunt resistor.

The apparatus 100 for diagnosing a battery according to an embodiment of the present disclosure may obtain voltage values of the battery B through the measurement device 12. For reference, the capacity of the battery B may be calculated by applying the current integration method.

The communication device 14 may be configured to perform communication with another device located remotely. For example, the communication device 14 may be configured to receive data transmitted from a remote server or communication terminal through a wired and/or wireless communication network and transmit the data to the apparatus 100 for diagnosing a battery, or transmit data generated in the apparatus 100 for diagnosing a battery to another server or communication terminal. To this end, the communication device 14 may include a communication modem that performs wired communication and/or wireless communication.

The charging/discharging device 16 may be configured to charge and/or discharge the battery B. To this end, the charging/discharging device 16 may include a charger for charging the battery B, a discharger for discharging the battery B, at least one switch for electrically connecting the battery B to terminals T1, T2 of the battery pack 10, etc.

The apparatus 100 for diagnosing a battery according to an embodiment of the present disclosure may control the charging/discharging device 16 to perform or stop charging or discharging of the battery B, set charging/discharging conditions, or change the set charging/discharging conditions.

The cooling device 18 may be configured to cool the battery B. To this end, the cooling device 18 may include a heat sink that absorbs heat from the battery B and releases it to the outside.

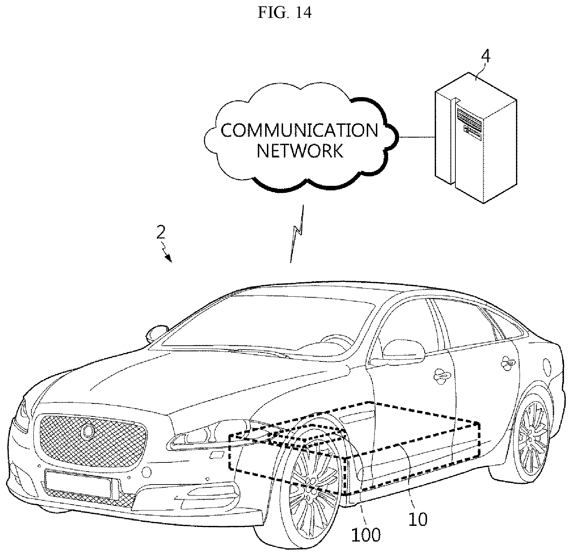

FIG. 14 is a drawing showing a vehicle 2 according to an embodiment of the present disclosure.

As illustrated in FIG. 14, the vehicle 2 according to an embodiment of the present disclosure may include a battery pack 10 that provides electrical energy necessary for the operation of the vehicle and the apparatus 100 for diagnosing a battery according to the present disclosure.

In this case, the apparatus 100 for diagnosing a battery may be configured to interact with an ECU (Electronic Control Unit) that controls the operation of the vehicle 2 or a BMS (Battery Management System) of the battery pack 10.

Additionally, the apparatus 100 for diagnosing a battery may be configured to receive data transmitted from a remote server 4 via a wired and/or wireless communication network, or to transmit data generated by the apparatus 100 for diagnosing a battery to the server 4.

For reference, the apparatus 100 for diagnosing a battery according to the present disclosure may be applied to various electrical devices or electrical systems other than vehicles, as well as to ESS (Energy Storage System).

Meanwhile, the embodiments according to the present disclosure may be implemented as a computer system and a computer program that operates the computer system. When the embodiments of the present disclosure are implemented as a computer program, the components of the present disclosure may include program segments that execute the corresponding operation or task through the corresponding computer system. These computer programs or program segments may be stored in various computer-readable recording media. The computer-readable recording media may include all types of media that record data readable by a computer system. For example, the computer-readable recording media may include a ROM, a RAM, an EEPROM, a register, a flash memory, a CD-ROM, a magnetic tape, a hard disk, a floppy disk, or an optical data recording device. In addition, these recording media may be distributed in various network-connected computer systems to store or execute program codes in a distributed manner.

As described above, according to an embodiment of the present disclosure, since a battery is diagnosed by generating a differential profile representing the relationship between the voltage and the differential capacity, which is obtained by differentiating the capacity of the battery with respect to the voltage of the battery, at each predetermined diagnosis cycle, the state of the battery may be diagnosed in real time.

In addition, according to an embodiment of the present disclosure, by detecting a target peak that shows a specific behavior over time among the peaks appearing in the differential profile and diagnosing the battery based on a change trend of at least one of the differential capacity value and the voltage value of the target peak, the change in the state of the battery may be precisely confirmed, and the accuracy and reliability of the diagnosis result may be improved.

In addition, according to an embodiment of the present disclosure, by reducing the voltage upper limit of the battery in response to the difference value between the first voltage value of the target peak obtained from the latest differential profile generated most recently among a plurality of differential profiles generated for each main cycle and the second voltage value of the target peak obtained from the differential profile generated immediately before the latest differential profile, efficient management corresponding to the current state of the battery is possible, and the life of the battery may be extended and safety may be improved.

Furthermore, the embodiments according to the present disclosure may solve various technical problems other than those mentioned in this specification in the corresponding technical field as well as in related technical fields.

The present disclosure has been described with reference to specific embodiments. However, those skilled in the art will clearly understand that various modified embodiments can be implemented within the technical scope of the present disclosure. Therefore, the embodiments disclosed above should be considered from an illustrative rather than a restrictive perspective. In other words, the true technical scope of the present disclosure is indicated by the claims, and all differences within the scope equivalent thereto should be interpreted as being included in the present disclosure.

## Claims

1. A method for diagnosing a battery, comprising:
a differential profile generating step of generating a differential profile representing a relationship between a differential capacity, which is obtained by differentiating a capacity of a battery with respect to a voltage of the battery, and the voltage, for each predetermined diagnosis cycle;
a target peak detecting step of detecting a target peak in which a differential capacity value decreases and then increases or a voltage value increases and then decreases as a usage time of the battery increases, among peaks of the differential profile;
a peak information obtaining step of obtaining target peak information including the differential capacity value and the voltage value of the target peak from each of the plurality of differential profiles generated while the diagnosis cycle is repeated multiple times; and
a diagnosing step of detecting a trend switching point at which a change trend of at least one of the differential capacity value and the voltage value of the target peak switches from an increasing trend to a decreasing trend or from a decreasing trend to an increasing trend over time based on the target peak information obtained from the plurality of differential profiles, and diagnosing a state of the battery by referring to the trend switching point.

2. The method for diagnosing a battery according to claim 1,
wherein the target peak detecting step includes:
a step of dividing an entire voltage section of the differential profile into a plurality of sub-sections different from each other and determining a target sub-section among the plurality of sub-sections; and
a step of detecting a peak located in the target sub-section among the peaks of the differential profile as the target peak.

3. The method for diagnosing a battery according to claim 2,
wherein the target sub-section is a section from 4.0 [V] to 4.2 [V].

4. The method for diagnosing a battery according to claim 1,
wherein the diagnosing step includes:
a step of detecting a first trend switching point at which the change trend of the differential capacity value switches from a decreasing trend to an increasing trend over time; and
a step of determining the state of the battery before the first trend switching point as a first deterioration state, and determining the state of the battery after the first trend switching point as a second deterioration state.

5. The method for diagnosing a battery according to claim 4,
wherein the diagnosing step further includes a step of determining that the battery needs to be replaced when the differential capacity value of the target peak exceeds a predetermined first threshold value after the first trend switching point.

6. The method for diagnosing a battery according to claim 1,
wherein the diagnosing step includes:
a step of detecting a second trend switching point at which the change trend of the voltage value switches from an increasing trend to a decreasing trend over time; and
a step of determining the state of the battery before the second trend switching point as a third deterioration state, and determining the state of the battery after the second trend switching point as a fourth deterioration state.

7. The method for diagnosing a battery according to claim 6,
wherein the diagnosing step further includes a step of determining that the battery needs to be replaced when the voltage value of the target peak decreases below a predetermined second threshold value after the second trend switching point.

8. The method for diagnosing a battery according to claim 1, further comprising:
a battery managing step of lowering a voltage upper limit of the battery when the trend switching point is detected in the diagnosing step.

9. The method for diagnosing a battery according to claim 8,
wherein the battery managing step includes:
a step of calculating a difference value between a first voltage value of the target peak obtained from a latest differential profile generated most recently among the plurality of differential profiles and a second voltage value of the target peak obtained from a differential profile generated immediately before the latest differential profile; and
a step of lowering the voltage upper limit of the battery in response to the difference value.

10. An apparatus for diagnosing a battery, comprising:
a differential profile generating unit configured to generate a differential profile representing a relationship between a differential capacity, which is obtained by differentiating a capacity of a battery with respect to a voltage of the battery, and the voltage, for each predetermined diagnosis cycle;
a peak information obtaining unit configured to detect a target peak in which a differential capacity value decreases and then increases or a voltage value increases and then decreases as a usage time of the battery increases, among peaks of the differential profile, and obtain target peak information including the differential capacity value and the voltage value of the target peak from each of the plurality of differential profiles generated while the diagnosis cycle is repeated multiple times; and
a diagnosing unit configured to detect a trend switching point at which a change trend of at least one of the differential capacity value and the voltage value of the target peak switches from an increasing trend to a decreasing trend or from a decreasing trend to an increasing trend over time based on the target peak information obtained from the plurality of differential profiles, and diagnose a state of the battery by referring to the trend switching point.

11. The apparatus for diagnosing a battery according to claim 10,
wherein the diagnosing step unit is configured to detect a first trend switching point at which the change trend of the differential capacity value switches from a decreasing trend to an increasing trend over time, determine the state of the battery before the first trend switching point as a first deterioration state, and determine the state of the battery after the first trend switching point as a second deterioration state.

12. The apparatus for diagnosing a battery according to claim 10,
wherein the diagnosing unit is configured to detect a second trend switching point at which the change trend of the voltage value switches from an increasing trend to a decreasing trend over time, determine the state of the battery before the second trend switching point as a third deterioration state, and determine the state of the battery after the second trend switching point as a fourth deterioration state.

13. The apparatus for diagnosing a battery according to claim 10, further comprising:
a battery management unit configured to lower a voltage upper limit of the battery when the trend switching point is detected.

14. A battery pack comprising the apparatus for diagnosing a battery according to any one of claims 10 to 13.

15. A vehicle comprising the apparatus for diagnosing a battery according to any one of claims 10 to 13.
